# EUROPEAN PATENT APPLICATION

(11) **EP 1 187 189 A1**
(43) Date of publication of application: **13.03.2002**
(21) Application number: 01902833.1
(22) Date of filing: 09.02.2001
(51) Int. Cl.: H01L 21/324

(54) **SILICON BOAT WITH PROTECTIVE FILM, METHOD OF MANUFACTURE THEREOF, AND SILICON WAFER HEAT-TREATED USING SILICON BOAT**

(30) Priority: 10.02.2000 JP 2000033381
(71) Applicant: Shin-Etsu Handotai Co., Ltd, Tokyo 100-0005 (JP)
(72) Inventor: KOBAYASHI, Norihiro c/o Shin-Etsu Handotai Co.,Ltd, Annaka-shi, Gunma 379-0196 (JP); AKIYAMA, Shoji c/o Shin-Etsu Handotai Co., Ltd., Annaka-shi, Gunma 379-0196 (JP); TAMATSUKA, Masaro c/o Shin-Etsu Handotai Co., Ltd., Annaka-shi, Gunma 379-0196 (JP); SHINOMIYA, Masaru c/o Shin-Etsu Handotai Co., Ltd., Annaka-shi, Gunma 379-0196 (JP)
(74) Representative: Cooper, John
(86) International application number: JP0100943
(87) International publication number: WO0159826

(57) **Abstract**

A silicon boat for supporting a silicon wafer during a heat treatment of the wafer, wherein a protective film consisting of a thermal oxide film is directly formed on a surface of the boat. A silicon boat is left in argon, hydrogen or a mixed gas of argon and hydrogen within a temperature range of 1000 °C or higher for 10 minutes or more to remove a native oxide film on the surface of the boat and then subjected to a heat treatment in an atmosphere containing oxygen to grow a protective film consisting of an oxide film on the surface of the boat. By using this silicon boat, silicon wafers are subjected to a heat treatment in an atmosphere consisting of argon or a mixed gas of argon and hydrogen. Thus, there are provided a boat for heat treatment of wafer and a method for heat treatment, of wafer, in which metal contamination is not caused in the wafer, and falling off of the protective film, damage of the wafer surface and generation of particles are prevented.

## Description

### Technical Field

The present invention relates to a heat treatment of a silicon wafer, in particular, a boat used for such a heat treatment and such a heat treatment in which metal contamination of a wafer is suppressed.

### Background Art

For example, a production process of a single crystal silicon wafer includes a step of heat treatment in which a wafer is placed on a jig called boat consisting of SiC or the like and heat-treated. In this heat treatment step, if the heat treatment is performed in a hydrogen or argon atmosphere and a boat made of SiC is used, both of surfaces of the wafer and the boat are etched, and impurities such as heavy metals contained in the base material of SiC may be transferred to the wafer to cause metal contamination.

On the other hand, if a boat made of silicon (Si) (also referred to as "Si boat" hereafter) is used, it is completely the same material as that of the wafer and hence a boat of low impurities can be produced. Therefore, contamination level will decrease. However, since the surface of Si boat is etched by hydrogen or argon annealing and as a result, Si atoms are exposed. Since they are active, the surface becomes likely to react with metals. That is, the boat made of Si itself is liable to get metal contamination, and if it once suffers from metal contamination, it is highly likely that it becomes a source of contamination thereafter.

On the other hand, a silicon wafer to be heat-treated is subjected to cleaning and so forth as preliminarily steps before the heat treatment, and it may be contaminated with metals contained in a cleaning solution. If a contaminated wafer. is placed on a Si boat as it is and subjected to a heat treatment, the boat is contaminated with contaminants adhered to the wafer. Therefore, if other wafers are subsequently subjected to a heat treatment by using that boat, even wafers not contaminated may be contaminated by the Si boat.

As described above, in the step of subjecting a wafer to a heat treatment in a hydrogen or argon atmosphere, the boat for heat treatment itself is etched by the atmospheric gas, and as a result, a wafer becomes likely to be influenced by the metal contamination of the boat.

The metal contamination in the heat treatment of wafers constitutes a serious problem, and if a wafer contains metal contamination after the heat treatment, for example, it may become a cause of yield reduction in a subsequent device production step. For example, when an oxide film is grown on a wafer surface, presence of metal contamination induces uneven thickness of the oxide film, and there is caused a problem that a leakage current is generated at a position having a smaller thickness of the oxide film. Furthermore, there may also be caused a problem that the metal contamination becomes oxidized metal and is not etched with an ordinary etching solution, and thus that position of the wafer surface is not oxidized in the subsequent steps.

Further, the metal contamination may affect an oxide film interface and degrade microroughness.

Thus, metal contamination adversely affects the device production step in various ways. Therefore, it is one of the most important objects to reduce the metal contamination.

By the way, as one of causes of yield reduction in the device production step, presence of COPs (Crystal Originated Particles) contained in wafers can be mentioned. As a technique for eliminating these COPs, there is known a technique of subjecting a wafer to a heat treatment (annealing) with hydrogen, argon (Ar) gas or the like at a high temperature.

However, if a wafer is subjected to a heat treatment in hydrogen or Ar gas at a high temperature, the amount of metal contamination will increase compared with usual high temperature oxidation performed at the same temperature for the same time. It is considered that this is caused because of the following reason. In the case of oxidation, an oxide film formed on a surface of wafer serves as a protective film for metal contamination. However, in the case of the high temperature heat treatment in a hydrogen atmosphere, Si is etched and an active Si surface is exposed. Thus, the surface becomes liable to be subjected to the influence of the metal contamination.

Therefore, the heat treatment utilizing hydrogen or the like that is an active gas at a high temperature inevitably suffers from the influence of metal contamination. Accordingly, there is desired a technique for reducing the metal contamination for the case where a wafer is subjected to a heat treatment at a high temperature in an atmosphere of hydrogen, argon or the like.

As a boat for preventing such metal contamination, Japanese Patent Laid-open (Kokai) Publication No. 8-148552 discloses a boat in which a silicon nitride film is thermally grown on an outermost surface of the boat by thermally growing a silicon nitride film on a surface of a boat made of Si or SiC, or by thermally growing a silicon oxide film and then thermally growing a nitride film on such a boat. A nitride film thermally grown on an outermost surface of a boat becomes a dense film, and prevents diffusion of metal impurities from the inside of the boat into a wafer.

However, since a coefficient of thermal expansion of the nitride film markedly differs from that of silicon, there is a problem that the nitride film becomes more likely to fall off as the film thickness becomes larger, when silicon is used as the material of the boat. Further, since the nitride film is harder than silicon, the nitride film formed on the outermost surface of the wafer boat damages the wafer surface, in particular, when a wafer having only a thin oxide film such as a native oxide film is subjected to a heat treatment, and thus dislocations may be generated from the damages as original points during the heat treatment. Furthermore, the hard nitride film may invite increase of silicon particles due to grinding of wafer in addition to particles of the nitride film itself.

When a thermal oxide film is formed and then a nitride film is formed as a protective film, falling off of the protective film itself is decreased compared with a case where only the nitride film is provided. However, since the outermost layer is the hard nitride film, there still remains the problem that it damages a wafer surface to generate particles and so forth.

Furthermore, when the protective film is subjected to a regenerating treatment, the removal of the nitride film requires a treatment with hot phosphoric acid or the like. Therefore, a boat on which a thick nitride film is formed suffers from a problem that regenerating treatment of the protective film becomes laborious.

### Disclosure of the Invention

Therefore, in order to solve the aforementioned problems, an object of the present invention is to provide a boat for heat treatments of wafer and a method for heat treatment of wafer, in which, even when a heat treatment using argon or the. like is performed, metal contamination is not caused in a wafer, in addition, a wafer surface is not damaged and particles are not generated.

In order to achieve the aforementioned object, the present invention provide a silicon boat for supporting a silicon wafer during a heat treatment of the wafer, wherein a protective film consisting of a thermal oxide film is directly formed on a surface of the boat.

If a silicon boat on which surface a protective film consisting of a thermal oxide film is directly formed as described above is used, the surface of the heat treatment boat is not etched by the atmospheric gas and thus the contamination of the boat itself can be prevented. Further, the generation of particles due to the falling off of the protective film or the like can also be prevented, and as a result, it enables heat treatment of a silicon wafer without contaminating the wafer.

Further, when the protective film is subjected to a regenerating treatment, the oxide film can be easily removed with hydrofluoric acid or the like and a thermal oxide film can be formed again. Thus, it also provides an advantage of very easy regenerating treatment.

In this case, the aforementioned protective film consisting of thermal oxide film preferably has a thickness of 100 nm or more.

By forming a protective film of such a thickness, the body of the Si boat can be surely protected, and generation of metal contamination can more surely be prevented.

In order to provide a silicon boat on which such a protective film as described above is formed, the present invention also provides a method for producing a silicon boat, which comprises leaving a silicon boat in argon, hydrogen or a mixed gas of argon and hydrogen within a temperature range of 1000°C or higher for 10 minutes or more to remove a native oxide film on a surface of the boat and then subjecting the boat to a heat treatment in an atmosphere containing oxygen to grow a protective film consisting of a thermal oxide film on the surface of the boat.

If a native oxide film is removed once and then a heat treatment is performed as described above, a protective film consisting of an oxide film can be directly formed on the surface of the boat, and thus the metal contamination of the heat treatment boat itself can be prevented.

In this case, it is preferable to grow a thermal oxide film having a thickness of 100 nm or more as the aforementioned protective film.

If the thickness of the oxide film is 1.00 nm or more as described above, it is not scarcely etched and pinholes are not generated even if a heat treatment is subsequently performed with Ar or the like'at a high temperature.

According to the present invention, there are further provided a method for heat treatment of a silicon wafer, wherein the silicon wafer is subjected to a heat treatment in an atmosphere consisting of argon or a mixed gas of argon and hydrogen by using the aforementioned silicon boat of the present invention, and a silicon wafet, wherein it is subjected to a heat treatment in an atmosphere consisting of argon or a mixed gas of argon and hydrogen by using the aforementioned silicon boat of the present invention.

In the silicon boat of the present invention, a protective film consisting of a thermal oxide film is formed on its surface, and generation of pinholes is suppressed and metal contamination and so forth are not caused even if a high temperature heat treatment in Ar or the like is performed. Therefore, if a silicon wafer is subjected to a heat treatment while supporting the silicon wafer with the silicon boat, the wafer does not suffer from metal contamination. Further, the thermal oxide film is not so hard as a nitride film and it is more unlikely to fall off compared with a nitride film. Therefore, in a wafer subjected to a heat treatment utilizing the silicon boat of the present invention, the surface is not damaged and particles are not adhered to the surface. Thus, the wafer can suitably be used in the subsequent device production step to provide good yield.

As explained above, the present invention provides a silicon boat on which surface a protective film consisting of a thermal oxide film is directly formed. If a silicon wafer is subjected to a heat treatment in an atmosphere consisting of argon or a mixed gas of argon and hydrogen by using such a silicon boat on which a protective film is formed, the boat itself is not etched by the atmospheric gas and the wafer can be subjected to a heat treatment while preventing metal contamination and generation of particles. Further, a wafer subjected to a heat treatment in the manner described above can be suitably used in the device production step.

### Brief Explanation of the Drawing

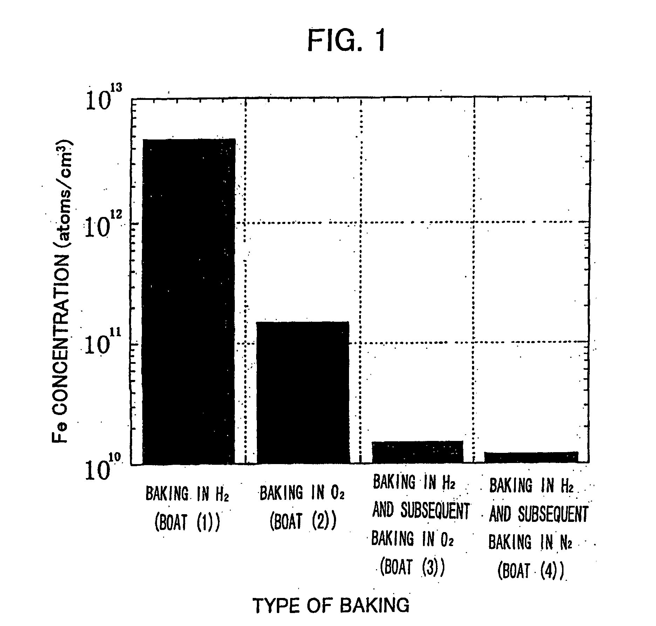

Fig. 1 is a graph showing Fe concentrations of silicon wafers subjected to an Ar heat treatment using Si boats subjected to different pretreatments.

### Best Mode for Carrying out the Invention

Hereafter, embodiments of the present invention will be explained specifically. However, the present invention is not limited to these.

According to the present invention, there is provided a silicon boat in which a protective film consisting of a thermal oxide film is directly formed on a surface of the boat, as a boat that does not impart metal contamination to a wafer, does not damage the wafer surface and does not generate particles even in a case where the wafer is subjected to a heat treatment at a high temperature by using argon or the like. That is, the boat for heat treatment of a wafer according to the present invention is a protective film consisting of a thermal oxide film is directly formed on a surface of the boat. The expression of "a protective film consisting of a thermal oxide film is directly formed on a surface of the boat" used herein means that a native oxide film is removed and the thermal oxide film is formed on an Si surface of the boat.

If an Si boat on which surface a native oxide film is formed is used as it is in a high temperature heat treatment of a wafer in an H₂ or Ar atmosphere, the native oxide film is removed by reduction or the like, or the native oxide film itself may be often contaminated. Thus, it does not function as a protective film. Therefore, according to the present invention, an Si boat is subjected to a heat treatment in an atmosphere of Ar or the like to remove the native oxide film, and then subjected to a heat treatment in an atmosphere containing oxygen to form a protective film consisting of a thermal oxide film directly on a boat surface. Since the thermal oxide film formed in the manner described above is dense, contains little impurities, and is free from generation of pinholes and so forth Therefore, it subsequently functions as a good protective film in a high temperature Ar heat treatment and so forth.

In order to form a protective film consisting of a thermal oxide film directly on a surface of Si boat as described above, first, a silicon boat can be left in argon, hydrogen or a mixed gas of argon and hydrogen within a temperature range of 1000°C or higher for 10 minutes or more to remove the native oxide film on the surface of the boat, and then it can be subjected to a heat treatment in oxygen atmosphere (baking) to grow a protective film consisting of an oxide film on a boat surface.

In this case, as for the removal of the natives oxide film, the etching rate of the native oxide film may become slow at a temperature lower than 1000°C, and thus the etching may become uneven. Further, with a period less than 10 minutes, the native oxide film may not be removed sufficiently. On the other hand, when the temperature is 1350°C or higher, silicon itself constituting the boat is softened, and there may be caused problems concerning metal contamination and durability of installations such as furnace. Further, the heat treatment for a period up to 120 minutes would be sufficient, and the productivity will be reduced if the heat treatment is performed for a further longer period.

On the other hand, if the temperature for the removal of the native oxide film is 1100°C or higher, there is caused migration of silicon atoms at the Si boat surface, and the surface is smoothed to invite reduction of particles during the heat treatment. Further, if the temperature is 1200°C or lower, the level of contamination from the furnace can be maintained to be low. Therefore, it is more preferable to perform the removal of native oxide film by leaving the boat within a temperature range of 1100°C to 1200°C for 10 to 120 minutes.

After the removal of the native oxide film, if an oxide film having a thickness of 100 nm or more is grown as the aforementioned protective film, generation of pinholes in the protective film can be surely prevented and a possibility of metal contamination of the boat itself will be markedly reduced.

In particular, it is preferable to form an oxide film having a thickness of 100 nm to 5 µm on the boat surface by the aforementioned baking. If a protective film having a thickness in this range is provided, pinholes are not generated even when the Ar annealing or the like is performed as described above, and it can be grown by an ordinary heat treatment step.

In order to grow a protective film having a thickness in the aforementioned range on a silicon boat surface, a native oxide film can be removed by a heat treatment in an atmospheric gas such as hydrogen as described above, and then the boat can be subjected to baking in an atmosphere containing oxygen within a temperature range of 1000°C to 1350°C for 10 minutes to 240 minutes depending on the desired thickness of the protective film. Such baking can be performed within ranges of temperature and time which can be used in a usual heat treatment step, and a protective film of a desired thickness can be easily formed.

The protective film consisting of a thermal oxide film formed as described above according to the present invention is dense and also excellent in adhesion property, and its thickness can be easily controlled. Therefore, it is not etched by an atmospheric gas such as Ar at the time of treatment of wafers. Further, the protective film itself does not contain impurities such as metals, and falling off is not observed and particles are not generated even after the boat is used many times. Therefore, there is not a possibility that a wafer may be contaminated by the protective film.

On the other hand, a conventional boat made of Si has a native oxide film formed thereon, because it is left in the atmospheric air or subjected to cleaning. However, the native oxide film has only a thickness of about 1 nm, in addition, uneven thickness, small density and bad adhesion property. Therefore, it cannot function as a protective film referred to in the present invention. Further, the native oxide film itself may contain metals that may be a source of contamination.

According to the present invention, a silicon wafer can be heat-treated without metal contamination of the wafer by subjecting the wafer to a heat treatment in an atmosphere of argon or mixed gas of argon and hydrogen using the Si boat of the present invention described above.

If a wafer is subjected to a heat treatment at a high temperature in an atmosphere consisting of Ar or a mixed gas of Ar and hydrogen, migration of Si occurs, COPs in the wafer are eliminated, and thus microroughness of the wafer surface is improved. At this time, the. wafer surface is etched and active Si is exposed as described above, and it becomes likely to get metal contamination. However, if the wafer is supported with a boat according to the present invention, in which a protective film consisting of a thermal oxide film is directly formed on its surface, the wafer is scarcely contaminated with metals from the boat. Further, since a protective film consisting of a thermal oxide film is unlikely to fall off, it does not generate particles. Furthermore, since a thermal oxide film is not so hard as nitride film, it does not damage a wafer surface.

However, when a wafer is subjected to a heat treatment at a high temperature in a mixed gas atmosphere of argon and hydrogen using an Si boat according to the present invention, a high hydrogen concentration accelerates the etching rate of the thermal oxide film on the surface of the boat, and therefore the hydrogen concentration is preferably low, in particular, the explosion limit (4% or less) or less. If the hydrogen concentration is 4% or less, the low hydrogen partial pressure lowers the etching rate of an oxide film, and therefore the thermal oxide film according to the present invention is not quickly etched and can sufficiently function as a protective film. Moreover, if the hydrogen concentration is low, there is also provided an advantage that special facilities such as explosion-proof facilities required for heat treatment in a high hydrogen concentration are not necessary.

As described above, a wafer to a heat treatment according to the present invention is free from metal contamination originated from a boat, and therefore an oxide film having a uniform thickness can be obtained on the wafer surface, for example, when the oxide film is grown in the subsequent device production step.

Furthermore, when the protective film of the boat according to the present invention is regenerated, the protective film can be extremely easily regenerated by removing the surface oxide film with hydrofluoric acid or the like and forming. a thermal oxide film again. When a silicon wafer is subjected to a heat treatment, for example, in a mixed gas atmosphere of argon and hydrogen using the Si boat according to the present invention, it is expected that the thermal oxide film on the surface of the boat is gradually etched, and its function as a protective film may be degraded. However, a protective film is easily regenerated by such a regenerated treatment as described above.

Hereafter, the present invention will be explained more specifically with reference to the following example and comparative examples. However, the present invention is not limited to these.

### (Example and Comparative Example)

First, silicon wafers were subjected to a heat treatment using boats consisting of Si single crystal and each subjected to one of four kinds of pretreatments, and then Fe concentration of the wafers was measured by the SPV method (Surface Photo Voltage method).

The Si boats used were chemically cleaned as a pretreatment, sufficiently dried, and then subjected to baking in a furnace according to each of the following conditions. After the baking, thickness of a protective film formed on the surface of each Si boat was measured.
(1) Baking at 1200°C for 120 minutes in a hydrogen atmosphere
(2) Baking at 1200°C for 120 minutes in an oxygen atmosphere
(3) Baking at 1200°C for 60 minutes in a hydrogen atmosphere, and then baking at 1200°C for 120 minutes in an oxygen atmosphere
(4) Baking at 1200°C for 60 minutes in a hydrogen atmosphere, and then baking at 1200°C for 120 minutes in a nitrogen atmosphere

The thickness of the protective film formed on the surface of each Si boat was as follows. As for the film thickness, when each Si boat surface is treated to form a protective film, one silicon wafer was placed on the boat to perform the treatment, and the thickness of the film formed on the wafer was measured by an ellipsometer and used as the thickness of the protective film formed on the boat surface.
(1) Almost no protective film
(2) Oxide film: 230 nm
(3) Oxide film: 230 nm
(4) Nitride film: 70 nm

Silicon wafers were also subjected to a heat treatment at 1200°C for 60 minutes in an Ar atmosphere by using the above boats, and the amounts of Fe contamination of the wafers were measured in terms of SPV. As the wafers, those having a specification of diameter: 200 mm, P type and 10 Ωcm were used.

The measured Fe concentrations in the wafers are shown in Fig. 1. As seen from the graph of the figure, the concentration was 4.5 x 10¹² atoms/cm³ when the boat of (1) was used, 1.4 x 1011 atoms/cm³ when the boat of (2) was used, and 1.4 x 10¹⁰ atoms/cm³ when the boat of (3) was used. Further, it was 1.1 x 10¹⁰ atoms/cm³ when the boat of (4) was used.

From these results, the Fe contamination was little when there were used the boats of (3) and (4), i.e., boats subjected to baking in a hydrogen atmosphere for the first stage and in oxygen or nitrogen for the second stage.

However, when the aforementioned heat treatment of silicon wafers was repeated thereafter by using these boats, adhesion of a lot of particles was observed on wafers subjected to the heat treatment by using the boat of (4), and it was found that falling off of the nitride film from the boat surface was caused. On the other hand, when the boat of (3) was used, adhesion of particles originated from the protective film (thermal oxide layer) was not observed.

Further, when the wafers subjected to the heat treatment by using the boat of (4) were observed by using a microscope, there were those slightly damaged at a position that was in contact with the boat.

When the boat of (1) was used, which was subjected to the baking only in a hydrogen atmosphere, the Fe concentration was high, and when the boat of (2) was used, which was subjected to the baking only in an oxygen atmosphere, in spite of the large thickness of the oxide film, the Fe concentration was higher compared with the cases where the boat of (3') or (4) was used. It is considered that these results were obtained for the following reasons.

When the boat subjected to the baking only in a hydrogen atmosphere ((1)) was used, a native oxide film was removed from the surface of the Si boat and Si was exposed at the surface. Therefore, trace amount metals from a silicon wafer and metals in a quartz tube and so forth. are likely todiffuse into the Si boat during the heat treatment, and it is highly possible that the metals came out from the Si boat again, and contaminated the wafers.

When the boat subjected to the baking only in an oxygen atmosphere ((2)) was used, pinholes were formed in the oxide film on the surface of the boat which underwent the heat treatment of wafers in an Ar atmosphere. This is the same as the phenomenon that pinholes are generated in an oxide film grown on a silicon wafer when the wafer is treated in an Ar atmosphere at a high temperature. It is considered that such generation of pinholes was caused by crystal defects in Si crystal that was a base material of the Si boat, presence of the intermediate native oxide film or metal contamination.

If pinholes are generated in the oxide film and Si is exposed as described above, the boat itself may be contaminated and, if contaminated, the boat itself may be a source of contamination. Thus, it is considered that baking only in oxygen was insufficient for prevention of metal contamination, but the effect of the protective film was higher than that of the boat of (1) because of adhesion of the thermal oxide film.

In the boat of (3), the first heat treatment in a hydrogen atmosphere removed the native oxide film and crystal defects present in the Si crystal that is the base material were eliminated. Then, during oxidation by the baking in an oxygen atmosphere, a thermal oxide film free from crystal defects was grown on the Si boat.

If the Ar heat treatment of wafers is performed by using this Si boat, pinholes are hot generated in the oxide film of the boat. Therefore, when the boat of (3) is used, the oxide film functions as a protective film, and contamination of the boat or contamination of wafer from the boat is prevented. Thus, it is considered to enable a heat treatment of wafers with least metal contamination.

Further, the thermal oxide film is unlikely to fall off even if it has a large thickness and thus it can effectively prevents generation of particles. Moreover, since it is not so hard as the nitride film of (4), it does not damage wafers.

In the boat of (4), a thermal nitride film was formed on a Si boat of which native oxide film was removed, by first performing a heat treatment under the same condition as the boat (3) (baking at 1200°C for 60 minutes in hydrogen atmosphere) and then performing nitriding through baking in a nitrogen atmosphere.

If the nitride film formation treatment is performed without the heat treatment in hydrogen atmosphere, a uniform nitride film cannot be obtained and thinner portions are formed. In such a case, such portions are etched during the subsequent heat treatment in an atmosphere of argon, hydrogen or a mixed gas thereof, and thus the film no longer functions as a protective film. Therefore, if both of the heat treatment in a hydrogen atmosphere and the growth of thermal nitride film are performed as in (4), the native oxide film is removed and an active Si surface is obtained, and thus more uniform nitride film is grown and functions as a protective film.

However, it was found that the nitride film was hard and might damage the wafer surface, and thus particles adhered to wafer surfaces due to falling off of the nitride film caused while the boat was used repeatedly.

The present invention is not limited to the embodiments described above. The above-described embodiments are mere examples, and those having the substantially same structure as that described in the appended claims and providing similar functions and advantages are included in the scope of the present invention.

For example, Si boats are classified into polyclystal Si boats and single crystal Si boats, and single crystal Si boats were used in the aforementioned example and comparative examples. However, the present invention is of course effective for both types of the boats.

## Claims

1. A silicon boat for supporting a silicon wafer during a heat treatment of the wafer, wherein a protective film consisting of a thermal oxide film is directly formed on a surface of the boat.

2. The silicon boat according to Claim 1, wherein the protective film consisting of thermal oxide film has a thickness of 100 nm or more.

3. A method for producing a silicon boat, which comprises leaving a silicon boat in argon, hydrogen or a mixed gas of argon and hydrogen within a temperature range of 1000°C or higher for 10 minutes or more to remove a native oxide film on a surface of the boat and then subjecting the boat to a heat treatment in an atmosphere containing oxygen. to grow a protective film consisting of a thermal oxide film on the surface of the boat.

4. The method for producing a silicon boat according to Claim 3, wherein a thermal oxide film having a thickness of 100 nm or more is grown as the protective film.

5. A method for heat treatment of a silicon wafer, wherein the silicon wafer is subjected to a heat treatment in an atmosphere consisting of argon or a mixed gas of argon and hydrogen by using the silicon boat according to Claim 1 or 2.

6. A silicon wafer, wherein it is subjected to a heat treatment in an atmosphere consisting of argon or a mixed gas of argon and hydrogen by using the silicon boat according to Claim 1 or 2.
